# EUROPÄISCHE PATENTSCHRIFT

(11) **EP 1 774 545 B1**
(45) Veröffentlichungstag und Bekanntmachung des Hinweises auf die Patenterteilung: **09.09.2009**
(21) Anmeldenummer: 05763335.6
(22) Anmeldetag: 01.07.2005
(51) Int. Cl.: H01F 27/02, H01F 27/29, H01F 17/06

(54) **HALTERUNG FÜR EINE ELEKTRISCHE KOMPONENTE**
HOLDER FOR ELECTRIC COMPONENTS
SUPPORT DESTINE A UN COMPOSANT ELECTRIQUE

(30) Priorität: 04.08.2004 DE 102004037844
(43) Veröffentlichungstag der Anmeldung: 18.04.2007
(73) Patentinhaber: EPCOS AG, 81669 München (DE)
(72) Erfinder: FEIST, Günter, 73333 Gingen/Fils (DE); ZIMMERMANN, Klaus, 89547 Gerstetten (DE)
(74) Vertreter: Epping - Hermann - Fischer
(86) Internationale Anmeldenummer: PCT/DE2005/001167
(87) Internationale Veröffentlichungsnummer: WO 2006/012822

(56) Entgegenhaltungen:
- DE-A1- 3 602 759
- US-A- 4 263 479
- US-A- 5 309 130
- US-B1- 6 757 180
- PATENT ABSTRACTS OF JAPAN Bd. 015, Nr. 191 (E-1068), 16. Mai 1991 (1991-05-16) -& JP 03 050807 A (MITSUBISHI ELECTRIC CORP), 5. März 1991 (1991-03-05)

## Beschreibung

Die Erfindung betrifft eine Halterung für eine elektrische Komponente, z. B. eine Ringkerndrossel, sowie ein Bauelement mit der elektrischen Komponente und der Halterung.

Kunststoffhalterungen für Ringkerndrosseln mit im Körper der Halterung eingespritzten Stecker- bzw. Anschlussstiften und Vorrichtungen zur Potentialtrennung von verschiedenen Drahtwicklungen der Ringkerndrossel sind z. B. aus den Druckschriften DE 3318527 A1, DE 9412107 U1, US 4,263,479, US 6,757,180, JP 03,050807, DE 26 02 759 und EP 0468314 B1 bekannt.

Aus der Druckschrift US 5309130 ist ein zur Oberflächenmontage geeignetes Bauelement mit einer Ringkerndrossel, die zwei Drahtwicklungen aufweist, und einer Halterung bekannt. Die Halterung weist eine Vertiefung auf, in der die Ringkerndrossel montiert ist. Am Körper der Halterung sind Vorsätze zum Aufwickeln von Drahtenden der Drahtwicklungen vorgesehen. In der Wand der Vertiefung sind Öffnungen vorgesehen, durch die die Drahtenden lose durchgeführt sind. Die Drahtenden sind an den jeweiligen Vorsätzen befestigt. Bei der Herstellung eines solchen Bauelements ist es schwierig, das Durchführen der Drahtenden durch die Öffnungen zu automatisieren.

Die Aufgabe der Erfindung ist es, eine Halterung für eine elektrische Komponente anzugeben, die zu einer vollautomatischen Herstellung des entsprechenden Bauelements geeignet ist.

Diese Aufgabe wird erfindungsgemäß durch eine Halterung mit den Merkmalen von Anspruch 1 und durch ein Bauelement mit der Halterung nach Anspruch 8 gelöst. Vorteilhafte Ausgestaltungen der Erfindung sind aus weiteren Ansprüchen zu entnehmen.

Die Erfindung gibt eine elektrisch isolierende Halterung zur Aufnahme einer elektrischen Komponente mit Drahtenden, die als elektrische Anschlüsse der Komponente dienen, an. Die Halterung weist einen Körper mit einem Mittelteil auf, in dem eine Vertiefung zur Aufnahme der Komponente ausgebildet ist. Die Seitenwände der Vertiefung weisen Schlitze auf, die zur Führung von Drahtenden der Komponente geeignet sind. Sowohl die Vertiefung als auch die Schlitze sind zu der selben Seite des Körpers hin offen. Diese Seite wird als Oberseite des Körpers bezeichnet (Oberbegriff des Anspruchs 1).

Das Fixieren von Drahtenden der elektrischen Komponente in den Schlitzen der diese Komponente aufnehmenden Vertiefung hat den Vorteil, dass der Abstand zwischen verschiedenen Drahtenden der Komponente durch den Abstand der Schlitze fest vorgegeben ist.

Die Halterung gemäß Erfindung kann in einem Bauelement mit einer elektrischen Komponente, z. B. Ringkerndrossel, eingesetzt werden. Die elektrische Komponente kann z. B. eine Ringkerndrossel mit einem geschlossenen Magnetkern und zwei verschiedenen, voneinander zu trennenden Drahtwicklungen sein. Die elektrische Komponente kann in der Vertiefung eingeklebt oder vergossen sein.

Der Schlitz stellt vorzugsweise einen Längsschlitz dar. Der Schlitz kann aber auch bezogen auf die Längsachse der Halterung schräg verlaufen.

Die Breite des Schlitzes ist in Abhängigkeit vom Durchmesser des Drahtendes vorzugsweise so gewählt, dass das Drahtende darin festgehalten, z. B. eingeklemmt wird.

Die Vertiefung ist vorzugsweise eine Sacklochvertiefung, also eine Vertiefung mit einem geschlossenen Boden. Der Boden der Vertiefung bildet im Bauelement außenseitig eine Fläche, die beispielsweise zur Beschriftung des Bauelements und zum Greifen mittels Vakuumgreifer genutzt werden kann.

Der Querschnitt der Vertiefung quer zur Längsachse der Halterung ist vorzugsweise an die Form der elektrischen Komponente angepasst.

Die Halterung weist erfindungsgemäß erste Vorsätze zum Aufwickeln von Drahtenden auf, wobei die ersten Vorsätze an den Seitenflächen der Halterung angeordnet sind. Ein erster Vorsatz kann einen vom Körper abgewandten Kragen aufweisen, dessen Fläche quer zur Längsachse des ersten Vorsatzes verläuft. Am ersten Vorsatz ist vorzugsweise eine Rille zur Führung des Drahtendes vorgesehen.

Beim Aufwickeln der Drahtenden auf die ersten Vorsätze werden Kontakte des Bauelements gebildet, wobei das Rastermaß zwischen verschiedenen Drahtenden nicht (durch weitere Maßnahmen) eingehalten werden muss. Dabei kann insbesondere auf weitere, z. B. im Körper der Halterung eingegossene Anschlusselemente wie Steckerstifte verzichtet werden.

Am Körper sind erfindungsgemäß zweite Vorsätze ausgebildet, die zwischen den Schlitzen und dem Ansatz von Rillen angeordnet sind und zur Führung der Drahtenden dienen. Die zweiten Vorsätze verhindern das Abrutschen des jeweiligen Drahtendes nach oben.

Der tiefste Punkt eines Schlitzes liegt vorzugsweise (z. B. um einen dem Drahtdurchmesser entsprechenden Wert) tiefer als die untere Kante der ersten oder des zweiten Vorsatzes. Das Drahtende wird dabei zwischen dem Schlitz und dem ihm entsprechenden ersten Vorsatz durch den zweiten Vorsatz im Wesentlichen parallel zur Bodenfläche des Körpers geführt.

Die Lage des ersten Vorsatzes und die Tiefe der Rille ist vorzugsweise so gewählt, dass die obere Kante des Drahtendes über die obere Fläche des Körpers hinausragt und einen zur Oberflächenmontage des Bauelements geeigneten elektrischen Kontakt bildet. Die Höhe der Vertiefung ist dabei vorzugsweise so gewählt, dass die elektrische Komponente nicht über den oberen Rand der Vertiefung hinausragt.

Die Halterung besteht vorzugsweise aus einem Kunststoff. Das Mittelteil, die ersten und die zweiten Vorsätze bilden vorzugsweise zusammen ein einstückiges Gehäuse bzw. Teilgehäuse des Bauelements.

Im folgenden wird die Erfindung anhand von Ausführungsbeispielen und der dazugehörigen Figuren näher erläutert. Die Figuren zeigen anhand schematischer und nicht maßstabsgetreuer Darstellungen verschiedene Ausführungsbeispiele der Erfindung. Gleiche oder gleich wirkende Teile sind mit gleichen Bezugszeichen bezeichnet. Es zeigen schematisch
Figur 1 die Ansicht der Halterung gemäß Erfindung von unten.
Figur 2A die Vorderansicht der Halterung gemäß Figur 1.
Figur 2B die Seitenansicht der Halterung gemäß Figuren 1, 2A.
Figur 3 die Ansicht der Halterung von oben.
Figur 4 die Ansicht eines Bauelements mit der Halterung gemäß den Figuren 1 bis 3 und einer Ringkerndrossel von unten.
Figur 5 die Vorderansicht des Bauelements gemäß Figur 4 in Vorderansicht.
Figur 6 die Ansicht des Bauelements gemäß Figuren 4, 5 von oben.

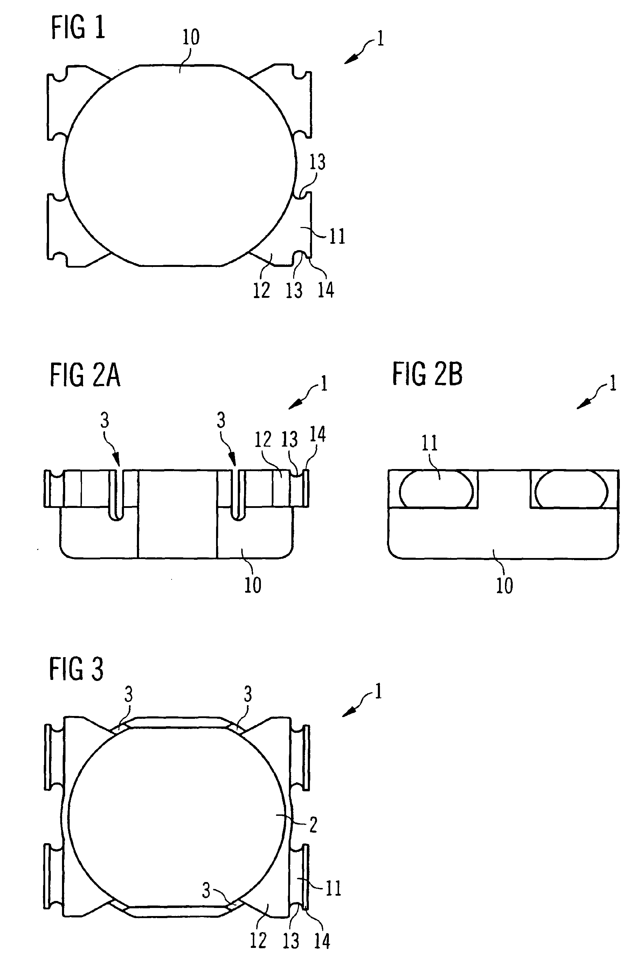

In den Figuren 1 bis 3 ist eine Halterung zur Aufnahme einer Ringkerndrossel gezeigt.

Figur 1 zeigt eine Halterung 1 mit einem Körper 10. Der Körper 10 weist einen Mittelteil auf, der zur Aufnahme der elektrischen Komponente, z. B. Ringkerndrossel, dient. Der Mittelteil des Körpers 10 ist im wesentlichen zylindrisch ausgebildet. Im Körper 10 sind vier erste Vorsätze 11 und vier zweite Vorsätze 12 ausgebildet, die jeweils mit dem Mittelteil 10 verbunden sind. Die Längsachse der ersten Vorsätze 11 verläuft parallel zur Oberseite des Körpers 10. Die ersten Vorsätze 11 sind auf einander gegenüberliegenden Seitenflächen des Körpers 10 angeordnet.

Die Vorsätze 11 (bzw. 12) sind spiegelsymmetrisch zueinander und vom Prinzip her gleich aufgebaut. Im weiteren wird nur ein erster und ein diesem entsprechender zweiter Vorsatz im Detail beschrieben. Die Beschreibung bezieht sich dabei auf alle in Figuren dargestellten ersten und zweiten Vorsätze.

Der erste Vorsatz 11 hat im Längsschnitt die Konfiguration eines Spulenkörpers. Der Vorsatz 11 weist einen Kragen 14 sowie eine Rille 13 zur Führung eines Drahtendes 51a auf.

In der Seitenwand des Mittelteils des Körpers 10 sind Schlitze 3 ausgebildet (Fig. 2A). Die Schlitze 3 sind zur Oberseite des Körpers 10 offen. Auch die Vertiefung 2 ist zur Oberseite des Körpers 10 offen.

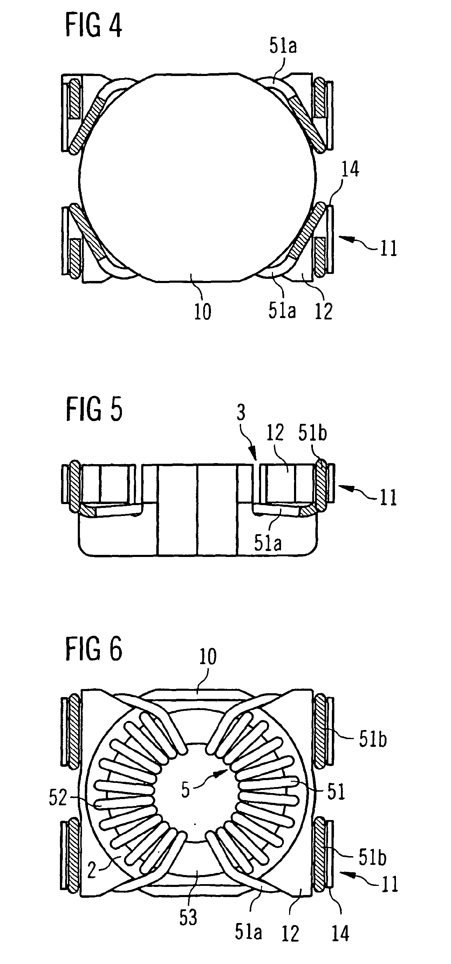

In Figur 2B ist gezeigt, dass die obere Kante des ersten Vorsatzes 11 parallel zur Oberseite des Körpers 10 verläuft. Dadurch gelingt es, in einem Bauelement mit der Halterung 1 einen parallel zur Oberseite des Körpers 10 verlaufenden, zur Oberflächenmontage geeigneten Kontakt des Bauelements herzustellen (Fig. 6).

In den Figuren 4 bis 6 ist ein Bauelement mit der Halterung 1 gemäß Erfindung und einer Ringkerndrossel 5 gezeigt. Die Ringkerndrossel 5 ist in der Vertiefung 2 des Körpers 10 liegend angeordnet, wobei die Höhe der Ringkerndrossel die Tiefe der Vertiefung 2 nicht übersteigt.

Die Vertiefung 2 ist zylindrisch ausgebildet. Die Ringkerndrossel 5 weist einen geschlossenen Magnetkern 53 sowie zwei Drahtwicklungen 51, 52 auf. Das Drahtende 51a der Drahtwicklung 51 wird zunächst in dem Schlitz 3 von oben eingeführt und dann unterhalb des zweiten Vorsatzes 12 zum ersten Vorsatz 11 hin geführt. Der zweite Vorsatz 12 verhindert das Abrutschen des Drahtendes 51a nach oben. Das Drahtende 51 ist um den ersten Vorsatz 11 gewickelt. Der Bauelementkontakt 51b des Bauelements ist durch einen über der Oberseite des Körpers 10 überstehenden Bereich des Drahtendes 51a gebildet.

Das Bauelement wird auf einer Leiterplatte mit seiner in Figur 6 gezeigten Oberseite nach unten bzw. zur Leiterplatte hin montiert. Die Bauelementkontakte 51b werden mit dafür vorgesehenen Anschlussflächen der Leiterplatte verlötet.

Das Drahtende 51a wird beim Umlaufen des ersten Vorsatzes 11 in der Rille 13 geführt. Der Kragen 14 dient auch zur Führung des Drahtendes 51a. Ein Teil des Drahtendes 51a ist verzinnt. Dies ist in den Figuren 4 bis 6 mit einer Schraffur dargestellt.

In der Figur 5 ist die Tiefe des Schlitzes 3 und die Höhe der unteren Kante des ersten und des zweiten Vorsatzes 11, 12 so gewählt, dass das Drahtende 51a bis zu seiner Einführung in die Rille 13 im wesentlichen parallel zu Oberseite des Körpers 10 geführt wird. Die Breite des Schlitzes 3 ist an die Querschnittsgröße des Drahtendes 51a formschlüssig angepasst. Das Drahtende wird im Schlitz 3 vorzugsweise eingeklemmt.

Die Erfindung ist nicht auf die hier gezeigten Ausführungsbeispiele oder eine bestimmte Materialauswahl beschränkt. Die vorgestellten Elemente können in beliebiger Anzahl und Anordnung miteinander kombiniert werden. Der Schlitz kann im Prinzip durch eine andere einseitig offene Vertiefung, z. B. eine Kerbe oder eine Nut ersetzt werden.

### Bezugszeichenliste

- 1: Halterung
- 10: Körper
- 11: erster Vorsatz
- 12: zweiter Vorsatz
- 13: Rille im Vorsatz 11
- 14: Kragen des ersten Vorsatzes 11
- 2: Vertiefung im Körper 10
- 3: Schlitz in der Seitenwand der Vertiefung 2
- 5: Ringkerndrossel
- 51: erste Drahtwicklung der Ringkerndrossel
- 51a: Drahtende
- 51b: Kontakt des Bauelements
- 52: zweite Drahtwicklung der Ringkerndrossel
- 53: geschlossener Magnetkern

## Patentansprüche

1. Halterung (1) zur Aufnahme einer elektrischen Komponente mit Drahtenden (51) als elektrische Anschlüsse der Komponente, aufweisend
einen Körper (10) mit einem Mittelteil, in dem eine Vertiefung (2) zur Aufnahme der Komponente ausgebildet ist, wobei Seitenwände der Vertiefung (2) Schlitze (3) aufweisen, die zur Führung von Drahtenden (51a) der Komponente geeignet sind,
wobei die Vertiefung (2) und die Schlitze zu der selben Seite des Körpers (10) hin offen sind,
**dadurch gekenzeichnet,**
dass erste Vorsätze (11), die zum Aufwickeln von Drahtenden (51a) der Komponente geeignet sind, an den Seitenflächen der Halterung (1) angeordnet sind,
wobei am Körper (10) zweite Vorsätze (12) ausgebildet sind, die zwischen den Schlitzen (3) und ersten Vorsätzen (11) angeordnet sind und zur Führung der Drahtenden (51a) geeignet sind.

2. Halterung nach Anspruch 1,
wobei die Längsachse der ersten Vorsätze (11) parallel zur Ebene, in der die Oberseite des Körpers (10) liegt, verläuft.

3. Halterung nach Anspruch 2,
wobei die ersten Vorsätze (11) jeweils auf ihrer vom Körper (10) abgewandten Seite einen Kragen (14) aufweisen, wobei die Begrenzungsfläche des Kragens quer zur Längsachse des entsprechenden ersten Vorsatzes (11) verläuft.

4. Halterung nach einem der Ansprüche 2 bis 3,
wobei die ersten Vorsätze (11) im Querschnitt die Form eines Spulenkörpers aufweisen.

5. Halterung nach einem der Ansprüche 2 bis 4,
wobei am ersten Vorsatz (11) eine Rille (13) zur Führung eines Drahtendes (51a) vorgesehen ist.

6. Halterung nach einem der Ansprüche 2 bis 5,
wobei die obere Kante der ersten Vorsätze (11) parallel zur Oberseite des Körpers (10) verläuft.

7. Halterung nach einem der Ansprüche 2 bis 6,
wobei die Enden der Schlitze (3) tiefer als die untere Kante der ersten Vorsätze (11) oder zweiten Vorsätze (12) positioniert sind.

8. Bauelement mit der Halterung nach einem der Ansprüche 1 bis 7,
mit der elektrischen Komponente,
wobei die elektrische Komponente nicht über den oberen Rand der Vertiefung (2) hinausragt.

9. Bauelement nach Anspruch 8,
wobei das Drahtende (51a) zwischen dem Schlitz (3) und dem ihm entsprechenden ersten Vorsatz (11) durch den zweiten Vorsatz (12) im Wesentlichen parallel zur Bodenfläche des Körpers (10) geführt wird.

10. Bauelement nach Anspruch 8 oder 9,
wobei die zweiten Vorsätze (12) das Abrutschen des jeweiligen Drahtendes (51a) nach oben verhindern.

11. Bauelement nach einem der Ansprüche 8 bis 10,
wobei die Lage des ersten Vorsatzes (11) und die Tiefe der Rille (13) so gewählt ist, dass die obere Kante des Drahtendes (51a) über die obere Fläche des Körpers (10) hinausragt und einen zur Oberflächenmontage des Bauelements geeigneten Kontakt (51b) bildet.

12. Bauelement nach einem der Ansprüche 8 bis 11,
wobei die elektrische Komponente eine Ringkerndrossel (5) ist, und
wobei die Drahtenden (51a) die Enden der Drahtwicklung (51) der Ringkerndrossel (5) sind.

13. Bauelement nach Anspruch 12,
bei dem die elektrische Komponente eine Ringkerndrossel (5) mit einem geschlossenen Magnetkern (53) und zwei verschiedenen Drahtwicklungen (51, 52) ist.

## Claims

1. Holder (1) for accommodating an electrical component with wire ends (51) as electrical connections of the component, having
a body (10) with a central part in which a recess (2) for accommodating the component is formed, with side walls of the recess (2) having slots (3) which are suitable for guiding wire ends (51a) of the component,
with the recess (2) and the slots being open towards the same side of the body (10),
**characterized**
**in that** first projections (11), which are suitable for having wire ends (51a) of the component wound on, are arranged on the side faces of the holder (1),
with second projections (12) being formed on the body (10), these second projections being arranged between the slots (3) and first projections (11) and being suitable for guiding the wire ends (51a).

2. Holder according to Claim 1,
with the longitudinal axis of the first projections (11) running parallel to the plane in which the upper side of the body (10) is situated.

3. Holder according to Claim 2,
with the first projections (11) each having a collar (14) on their side which is averted from the body (10), with the boundary face of the collar running transverse to the longitudinal axis of the corresponding first projection (11).

4. Holder according to either of Claims 2 and 3,
with the first projections (11) having the shape of a coil former in cross section.

5. Holder according to one of Claims 2 to 4,
with a channel (13) for guiding a wire end (51a) being provided on the first projection (11).

6. Holder according to one of Claims 2 to 5,
with the upper edge of the first projections (11) running parallel to the upper side of the body (10).

7. Holder according to one of Claims 2 to 6,
with the ends of the slots (3) being positioned deeper than the lower edge of the first projections (11) or second projections (12).

8. Structural element having the holder according to one of Claims 1 to 7,
having the electrical component,
with the electrical component not protruding beyond the upper border of the recess (2).

9. Structural element according to Claim 8,
with the wire end (51a) being guided between the slot (3) and its corresponding first projection (11), through the second projection (12), substantially parallel to the bottom face of the body (10).

10. Structural element according to Claim 8 or 9,
with the second projections (12) preventing the respective wire end (51a) from slipping off at the top.

11. Structural element according to one of Claims 8 to 10,
with the position of the first projection (11) and the depth of the channel (13) being selected such that the upper edge of the wire end (51a) protrudes beyond the upper face of the body (10) and forms a contact (51b) which is suitable for surface-mounting the structural element.

12. Structural element according to one of Claims 8 to 11,
with the electrical component being a toroidal core inductor (5), and
with the wire ends (51a) being the ends of the wire winding (51) of the toroidal core inductor (5).

13. Structural element according to Claim 12,
in which the electrical component is a toroidal core inductor (5) with a closed magnet core (53) and two different wire windings (51, 52).

## Revendications

1. Fixation (1) de réception d'un composant électrique ayant des extrémités (51) de fil comme bornes électriques du composant, comprenant :
un corps (10) ayant une partie médiane dans laquelle est formée une cavité (2) de réception du composant, des parois latérales de la cavité (2) ayant des fentes (3) propres à guider des extrémités (51a) de fil du composant ,
la cavité (2) et les fentes débouchant du même côté du corps (10),
**caractérisé**
**en ce que** des premiers adaptateurs (11), qui sont appropriés pour l'enroulement d'extrémités (51a) de fil du composant, sont disposés sur les surfaces latérales de la fixation (1),
des deuxièmes adaptateurs (12), qui sont disposés entre les fentes (3) et les premiers adaptateurs (11) et qui sont propres à guider les extrémités (51a) de fil, étant formés sur le corps (10).

2. Fixation suivant la revendication 1, dans laquelle l'axe longitudinale des premiers adaptateurs (11) s'étend parallèlement au plan dans lequel se trouve la face supérieure du corps (10).

3. Fixation suivant la revendication 2, dans laquelle les premiers adaptateurs (11) ont un collet (10) respectivement sur leur côté éloigné du corps (10), la surface de démarcation du collet s'étendant transversalement à l'axe longitudinal du premier adaptateur (11) correspondant.

4. Fixation suivant l'une des revendications 2 à 3, dans laquelle les premiers adaptateurs (11) ont en section transversale la forme d'un corps de bobine.

5. Fixation suivant l'une des revendications 2 à 4, dans laquelle il est prévu sur le premier adaptateur (11) une nervure (13) de guidage d'une extrémité (51a) de fil.

6. Fixation suivant l'une des revendications 2 à 5, dans laquelle le bord supérieur des premiers adaptateurs (11) s'étend parallèlement à la face supérieure du corps (10).

7. Fixation suivant l'une des revendications 2 à 6, dans laquelle les extrémités des fentes (3) sont placées plus profondément que les bords inférieurs des premiers adaptateurs (11) ou des deuxièmes adaptateurs (12).

8. Composant ayant la fixation suivant l'une des revendications 1 à 7,
comprenant le composant électrique,
dans lequel le composant électrique ne dépasse pas du bord supérieur de la cavité (2).

9. Composant suivant la revendication 8, dans lequel l'extrémité (51a) du fil est guidé entre la fente (3) et le premier adaptateur (11) qui lui correspond sensiblement parallèlement à la surface de fond du corps (10) par le deuxième adaptateur (12).

10. Composant suivant la revendication 8 ou 9, dans lequel les deuxième adaptateurs (12) empêchent le glissement vers le haut de l'extrémité (51a) de fil respective.

11. Composant suivant l'une des revendications 8 à 10, dans lequel la position du premier adaptateur (11) et la profondeur de la rainure (13) sont choisies de façon à ce que le bord supérieur de l'extrémité (51a) des fils dépasse de la surface supérieure du corps (10) et forme un contact (51b) adapté au montage en surface du composant.

12. Composant suivant l'une des revendications 8 à 11, dans lequel le composant électrique est une bobine (5) à noyau torique, et
dans lequel les extrémités (51a) de fil sont les extrémités de l'enroulement (51) de fil de la bobine (5) à noyau torique.

13. Composant suivant la revendication 12, dans lequel le composant électrique est une bobine (5) à noyau torique ayant un noyau (53) magnétique fermé et deux enroulement (51, 52) de fil distincts.
